Europäisches Patentamt

European Patent Office

Office européen des brevets

(19)

(11) Veröffentlichungsnummer: **0 099 979**
**B1**

(12) **EUROPÄISCHE PATENTSCHRIFT**

(45) Veröffentlichungstag der Patentschrift:
**08.04.87**

(21) Anmeldenummer: **83105686.6**

(22) Anmeldetag: **10.06.83**

(51) Int. Cl.⁴: **G 01 R 33/06,** H 01 L 29/82,
H 01 L 29/10

(54) **Magnetfeldsensor und dessen Verwendung.**

(30) Priorität: 26.07.82 GB 8221522
30.11.82 GB 8234054

(43) Veröffentlichungstag der Anmeldung:
08.02.84 Patentblatt 84/6

(45) Bekanntmachung des Hinweises auf die Patenterteilung:
08.04.87 Patentblatt 87/15

(84) Benannte Vertragsstaaten:
AT CH DE FR IT LI NL SE

(56) Entgegenhaltungen:
DE-A-2 709 457
DE-A-3 133 908
FR-A-2 345 814
FR-A-2 504 272
GB-A-895 629
GB-A-2 029 973
GB-A-2 064 140
US-A-3 693 085
US-A-3 911 468
US-A-4 100 563
US-A-4 240 059
US-A-4 309 655

ELECTRONICS, 19-05-1982, New York, US R.
BERESFORD: "Magnetic transistors exploit new
theory of carrier modulation", Seiten 45-46
IBM TECHNICAL DISCLOSURE BULLETIN, Band 18,

(73) Patentinhaber: LGZ LANDIS & GYR ZUG AG, CH-
6301 Zug (CH)

(72) Erfinder: Popovic, Radivoje, Zugerstrasse 24, CH-
6312 Steinhausen (CH)
Erfinder: Baltes, Heinrich Peter, University of
Alberta, Edmonton Alberta, T6G 2E1 (CA)

(74) Vertreter: Müller, Hans- Jürgen, Dipl.- Ing., Müller,
Schupfner & Gauger Lucile- Grahn- Strasse 38
Postfach 80 13 69, D-8000 München 80 (DE)

(56) Entgegenhaltungen: (Fortsetzung)
Heft 8, 8.Januar 1976, New York, US C.H. BAJOREK
et al:"Magnetoresistive current sensor", Seiten
2745-2748

## Beschreibung

Die Erfindung bezieht sich auf einen Magnetfeldsensor gemäß dem Oberbegriff des Anspruchs 1.

Aus der Zeitschrift Electronics, Mai 19, 1982, Seiten 45-46, R. Beresford, "Magnetic transistors exploit new theory of carrier modulation" ist bereits ein solcher Magnetfeldsensor bekannt, bei dem ein Magnetfeld die Elektronenin-Jizierung des Emitters in einem Magnetotransistor moduliert.

Ein Magnetotransistor ist technologisch gesehen ein mehr oder weniger standardmäßiger Bipolartransistor, dessen Entwurf so optimiert ist, daß eine hohe Empfindlichkeit seiner Ausgangsdaten, z.B. seines Kollektorstromes I oder seines Stromverstärkungsfaktores, in Abhängigkeit des Wertes und der Richtung eines Magnetfeldes erzielt wird. Magnetotransistoren besitzen in der Regel eine Spannungs-Empfindlichkeit von 10 Volt/Tesla bis 500 Volt/Tesla bzw. eine Relativstrom-Empfindlichkeit von 20%/Tesla bis 30%/Tesla und bestehen vorzugsweise aus lateralen Bipolartransistoren.

Aus der Zeitschrift Sov. Phys. Semicond. 12(1), Januar 1978, Seiten 26 - 28, I.M. Mitnikova et al. "Investigation of the characteristics of silicon lateral magnetotransistors with two measuring collectors" ist bekannt, daß unter anderem die Magnetokonzentration einen großen Einfluß hat auf die Empfindlichkeit eines Magnetotransistors.

In der Schweizer Patentanmeldung Nr. 3679/82, R.S. Popovic et al., ist ein neues Konzept beschrieben zur Auswertung des Magnetodioden-Effektes.

Aus der US-PS 4 100 563 ist ein Magnetfeldsensor bekannt, der zwei Kollektor- und zwei Basis-Schichten besitzt, wobei die Verbindungslinien zwischen den beiden gleichnamigen Schichten senkrecht zueinander angeordnet sind. Außerdem wirkt das zu messende Magnetfeld senkrecht zur Oberfläche des Magnetfeldsensors.

Der Erfindung liegt die Aufgabe zugrunde, die Empfindlichkeit von Magnetfeldsensoren, die mittels lateralen Magnetotransistoren aufgebaut Sind, zu erhöhen.

Die Erfindung ist im Patentanspruch 1 gekennzeichnet. Ein solcher Magnetfeldsensor wird zweckmäßigerweise als Stromsensor im Eingangskreis eines Elektrizitätszählers verwendet, kann aber auch als Positionssensor in einem magnetischen Endschalter verwendet werden.

Ausführungsbeispiele der Erfindung sind in der Zeichnung dargestellt und werden im folgenden näher beschrieben:

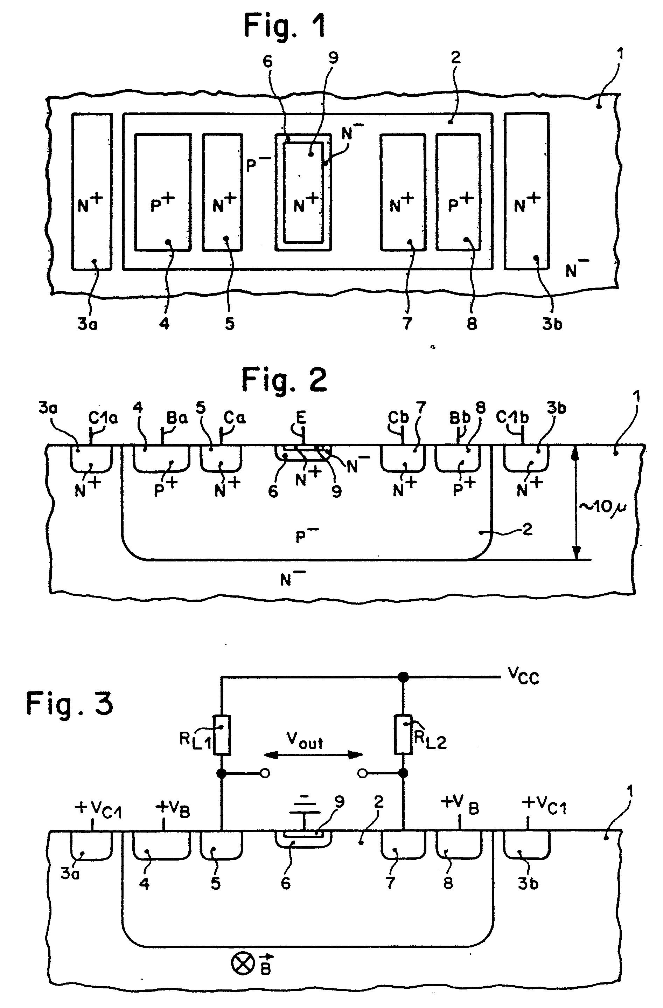

Es zeigen: Fig. 1 eine Draufsicht eines Magnetfeldsensors,

Fig. 2 einen Querschnitt des gleichen Magnetfeldsensors,

Fig. 3 einen Schaltkreis mit einem Magnetfeldsensor,

Fig. 4 ein Detail des Magnetfeldsensors,

Fig. 5 eine Kennlinie des Kollektorstromes $I_c$ des Magnetfeldsensors in Funktion von dessen Kollektorspannung $V_{CE}$,

Fig. 6 einen Ausschnitt des Querschnitts eines Magnetfeldsensors mit drei Unterschichten in der Emitter-Schicht,

Fig. 7 ein Ersatzschaltbild des Magnetfeldsensors nach Fig. 6,

Fig. 8 einen Ausschnitt des Querschnitts eines Magnetfeldsensors mit zwei Unterschichten in der Emitter-Schicht,

Fig. 9 ein Ersatzschaltbild des Magnetfeldsensors nach Fig. 8,

Fig. 10 einen Ausschnitt des Querschnitts eines Magnetfeldsensors mit einer Vielzahl von abwechselnden Unterschichten P+ und N+ in der Emitter-Schicht,

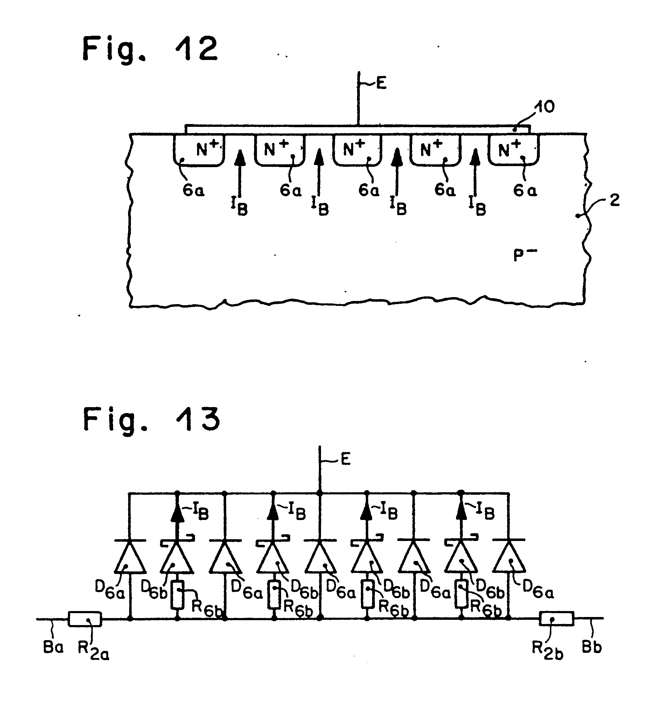

Fig. 1 1 ein Ersatzschaltbild des Magnetfeldsensors nach Fig. 10,

Fig. 12 einen Ausschnitt des Querschnitts eines Magnetfeldsensors mit einer Vielzahl von Unterschichten N+ in der Emitter-Schicht und

Fig. 13 ein Ersatzschaltbild des Magnetfeldsensors nach Fig. 12.

Gleiche Bezugszahlen bezeichnen in allen Figuren der Zeichnung gleiche Teile.

## Beschreibung

Als Beispiel wird ein bipolarer NpN-Magnetotransistor beschrieben. Statt mit einem NpN- kann der Magnetfeldsensor jedoch auch mit einem PNP-Magnetotransistor aufgebaut werden, unter Berücksichtigung der dann üblichen und aus der Transistortechnik her bekannten Umkehrungen der Material-Leitfähigkeitstypen. Der Magnetfeldsensor kann mittels einer CMOS-Technologie hergestellt werden.

Gemäss der Fig. 1 und der Fig. 2 besteht der Magnetfeldsensor aus einem gewöhnlichen monokristallinen Siliziumsubstrat 1 aus schwach mit Fremdatomen dotiertem N-Material, d.h. aus N⁻-Material, dessen Resistivität annähernd ein Ohm. cm ist. Unter Verwendung bekannter Prozeßschritte aus der Technologie der integrierten Schaltungen werden folgende Schichten im Siliziumsubstrat 1 an dessen Oberfläche gebildet durch Ionenimplantation und/oder durch Diffusion von Fremdatomen in das Siliziumsubstrat 1:

- eine P⁻-Wanne aus schwach mit Fremdatomen dotiertem P-Material als Basis-Schicht 2 und

- je eine annähernd gleich hohe links und rechts von der P⁻-Wanne angeordnete stark mit Fremdatomem dotierte N+-Schicht aus N-Material zur Bildung je eines Kollektor-Sekundärkontaktes 3a bzw. 3b.

0 099 979

Auf die gleiche Art werden in der P⁻ -Wanne an deren Oberfläche folgende gleich hohe Schichten erzeugt, die in der Darstellung der Zeichnung von links nach rechts nebeneinander auf einer Linie angeordnet sind:
- eine stark mit Fremdatomen dotierte erste P+ -Unterschicht als erster Basis-Kontakt 4,
- eine stark mit Fremdatomen dotierte erste N+ -Unterschicht als erste Kollektor-Schicht 5,
- eine schwach mit Fremdatomen dotierte N⁻ -Unterschicht als Emitter-Schicht 6,
- eine stark mit Fremdatomen dotierte zweite N+ -Unterschicht als zweite Kollektor-Schicht 7 und
- eine stark mit Fremdatomen dotierte zweite P+ -Unterschicht als zweiter Basis-Kontakt 8.

Die Emitter-Schicht 6 ist annähernd in der Mitte der Basis-Schicht 2 angeordnet und besitzt an ihrer Oberfläche eine sehr dünne, stark dotierte N+ -Oberflächenschicht zur Bildung eines ohmischen Emitter-Kontaktes 9. Die vier anderen Unterschichten sind symmetrisch zur Emitter-Schicht 6 angeordnet. Jede Kollektor-Schicht 5 bzw. 7 befindet sich zwischen der gemeinsamen Emitter-Schicht 6 und einem ihr zugehörigen Basis-Kontakt 4 bzw. 8. Die beiden Kollektor-Sekundärkontakte 3a und 3b, die beiden Kollektor-Schichten 5 und 7 sowie der Emitter-Kontakt 9 können z.B. alle gleich stark dotiert sein. Die Basis-Schicht 2 besitzt vorzugsweise eine Resistivität von einem Kiloohm pro Quadrat und eine Diffusionstiefe von annähernd 10 µm. Die Basis-Kontakte 4 und 8, sowie die Kollektor-Schichten 5 und 7 besitzen je eine Resistivität, die kleiner oder gleich fünfzig Ohm pro Quadrat ist, und eine Diffusionstiefe, die grösser oder annähernd gleich 1 µm ist.

Ein kritischer Punkt im Entwurf des Magnetfeldsensors ist die Bemessung der Emitter-Schicht 6. Ihre Resistivität sollte grösser als hundert Ohm pro Quadrat und ihre Diffusionstiefe sehr klein sein, letztere jedoch nicht kleiner als 0,5 µm, da ansonsten die metallische Emitter-Anschlussverbindung leicht den Emitter/ Basis-Uebergang durchstossen könnte.

Der Emitter-Kontakt 9 dient der Bildung eines guten ohmischen Kontaktes als Zugang zu der Emitter-Schicht 6, gemäss einem Verfahren, welches in der Zeitschrift Solid State Electron ics, 21/1978, Seiten 1 133 - 1138, R.S. Popovic, beschrieben ist.

Aus der Fig. 2 ist der P⁻/N⁻-Uebergang, welcher als Sperrschicht arbeitet, zwischen der Basis-Schicht 2 und dem Siliziumsubstrat 1 ersichtlich.

Die restlichen strukturellen Details des Magnetfeldsensors sind bekannt und werden daher in den Figuren 1 und 2 nicht näher dargestellt. Insbesondere ist das gesamte Bauelement mit einer nicht dargestellten Passivationsschicht, z.B. aus Silizium-Dioxyd, bedeckt. Die Schichten bzw. Kontakte 3a, 4, 5, 9, 7, 8 und 3b besitzen je einen metallenen Anschluss, nämlich in der angegebenen Reihenfolge einen ersten Kollektor-Sekundäranschluss Cla, einen ersten Basisanschluss Ba, einen ersten Kollektoranschluss Ca, einen Emitteranschluss E, einen zweiten Kollektoranschluss Cb, einen zweiten Basisanschluss Bb und einen zweiten Kollektor-Sekundäranschluss Clb.

In der Fig. 3 ist der Emitter-Kontakt 9 und damit die Emitter-Schicht 6 extern geerdet, und eine positive Spannung $+V_{cc}$ liegt über je einen getrennten Lastwiderstand $R_{L1}$ bzw. $R_{L2}$ am ersten bzw. zweiten Kollektoranschluss Ca bzw. Cb. Diese Lastwiderstände können z.B. MOS-Transitoren sein. Eine Ausgangsspannung $V_{out}$ erscheint zwischen den beiden Kollektoranschlüssen Ca un Cb. Eine positive Spannung $+V_B$ liegt an den beiden Basisanschlüssen Ba und Bb sowie eine positive Spannung $+V_{C1} > +V_B$ an den beiden Kollektor-Sekundäranschlüssen C1a und C1b. Die Schaltung nach Fig. 3 unterscheidet sich von gebräuchlichen üblichen Transistorschaltungen vorallem einerseits durch die Anwesenheit der beiden Kollektor-Sekundärkontakte 3a und 3b, die nur dazu dienen die Spannung $+V_{C1}$ am Siliziumsubstrat 1 anzulegen und anderseits durch das Vorhandensein der P⁻-Wanne.

In der Fig. 3 wurde das Vorhandensein eines Magnetflusses $\vec{B}$ parallel zur Oberfläche des Magnetfeldsensors und senkrecht zur Papierebene vorausgesetzt. Ein vorteilhafter Einsatz des Magnetfeldsensors besteht z.B. in seiner Verwendung als Differentialverstärker.

Wird eine Schaltung mit einem einpoligen Ausgang benötigt, so kann dazu die linke oder die rechte Hälfte des Magnetotransistors gemäss der Fig. 3 mit der dazugehörigen halben Beschaltung verwendet werden.

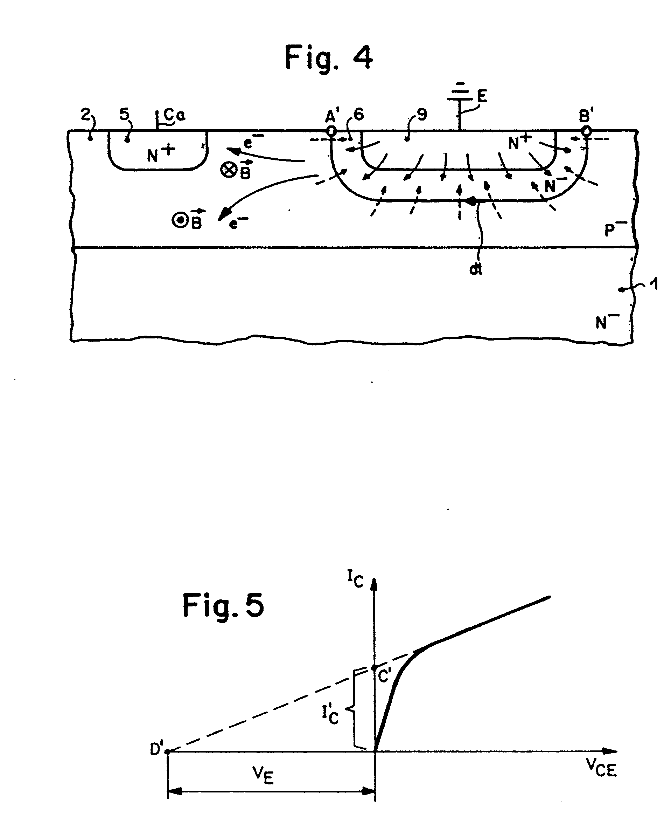

In der Detaildarstellung der Fig. 4, die die Emitter-Schicht 6 und die erste Kollektor-Schicht 5 des Magnetfeldsensors wiedergibt, stellen durchgezogene Pfeile Elektronenbewegungen und unterbrochene Pfeile Löcherbewegungen dar. Der äussere Umfang der Emitter-Schicht 6 reicht im Querschnitt der Fig. 4 vom ersten Oberflächenpunkt A' bis zum zweiten Oberflächenpunkt B'.

Durch den Aufbau Hallspannung-ähnlicher Spannungen in der Nähe des Basis/Emitter-Ueberganges entsteht eine asymmetrische Elektronen-Injizierung. Ausserdem werden die Ladungsträger zusätzlich noch durch die Lorentzkraft abgelenkt.

Die entlang der gekrümmten Linie A' B' erzeugte Hallspannung ist:

$$V_{A'-B'}^{H} = \int_{B'}^{A'} \vec{E}^{H} \cdot \vec{dl} \quad (1),$$

3

wobei $\vec{E}^H$ das lokale Hallfeld und $\vec{dl}$ ein unendlich kleines Element der Linie A' B' darstellt.

Es gilt $\vec{E}^H = R_H \cdot \vec{J} \times \vec{B}$ (2) wobei $R_H$ den Hall-Koeffizient, $\vec{B}$ die Magnetinduktion und $\vec{J}$

die lokale elektrische Stromdichte darstellt.

Es gelten: $R_H = \frac{r \cdot (p - b^2 n)}{q \cdot (p + bn)^2}$ (3),

$b = \frac{\mu_n}{\mu_p}$ (4) und

$r = <\tau^2> / <\tau>^2$ (5),

wobei $<\tau^2>$ den Mittelwert von

$<\tau>$ den Mittelwert von,

q die Ladung eines Elektrons,

n die Elektronendichte,

p die Löcherdichte,

$\mu_n$ die Beweglichkeit ("mobility") der Elektronen,

$\mu_p$ die Beweglichkeit der Löcher und

$\tau$ die mittlere freie Zeit zwischen zwei Zusammenstössen darstellt.

Dringt die Magnetinduktion $\vec{B}$

in die Papierebene ein (Darstellung $\otimes$ in der Fig. 4), so werden beide Trägertypen, d.h. Elektronen und Löcher, entlang der Linie A'-B' vom Oberflächenpunkt B' zum Oberflächenpunkt A' abgelenkt, d.h. sind ihre Konzentrationen p und n annähernd gleich gross, so wird $R_H$ gemäss der Gleichung (3) und damit auch die Hallspannung nach Null streben. Ist jedoch der Wirkungsgrad des Emitters sehr klein, dann gilt p > > n. Der Hall-Koeffizient $R_H$ wird gleich $r/2_p$ und der Oberflächenpunkt A' wird spannungsmässig positiver als der Oberflächenpunkt B'. Entsprechend werden in der Darstellung der Fig. 4 mehr Elektronen links als rechts injiziert, so dass das entsprechende Stromverhältnis gleich

$\frac{J_{A'}}{J_{B'}} = e^{\frac{q\,V''_{A'-B'}}{kT}}$ (6)

wird. Ausserdem werden die Ladungsträger beim Oberflächenpunkt A' nach oben hin abgelenkt und durch die erste Kollektor-Schicht 5 aufgefangen, während die beim Oberflächenpunkt B' injizierte Träger nach unten abgelenkt und durch das Siliziumsubstrat 1 aufgefangen werden. Dieser Effekt verstärkt noch zusätzlich den Wert des Stomverhältnisses gemäss Gleichung (6). Die Kombination beider Effekte erhöht somit die Empfindlichkeit des Magnetfeldsensors.

Der Kollektorausgangswiderstand des Magnetotransistors beträgt

$r_c = \Delta V_c / \Delta I_c \cong V_E / I'_c$ (7),

wobei die Bedeutung von $V_E$ und $I'_C$ aus der Fig. 5 ersichtlich ist.

Die höchste erhältliche Kollektorausgangsspannung des Magnetotransistors ist gleich $\Delta V_{max} = r_c \cdot \Delta I_C$ (8) und somit ist unter Berücksichtigung der Gleichung (8) die grösste Spannungsempfindlichkeit gleich

$S_{V\,max} = \Delta V_{max} / \Delta B = r_c \cdot \Delta I_{c/\Delta B}$.

Wird $r_c$ durch seinen Wert gemäss Gleichung (7) ersetzt, so gilt

$S_{V\,max} = (V_E / I'_c) \cdot (\Delta I_c / \Delta B)$

$= V_E \, S_{Ic}$ mit $S_{I_c} \cdot (\Delta I_c / I'_c)/\Delta B$.

Die so erhaltene Relativstrom-Empfindlichkeit gegenüber dem Magnetfeld ist mindestens annähernd dreimal so gross, d.h. $\geq$ 100%/Tesla, als bei den bischer bekannten Magnetotransistoren gemäss dem Stand der Technik.

Ein weiterer Vorteil des beschriebenen Magnetfeldsensors ist sein kleines magnetempfindliches Volumen, welches nur $5.10^{-5}$ mm$^3$ beträgt im Gegensatz zu den bei Mitnikova et al erwähnten $5.10^{-3}$mm$^3$. Auf Kosten einer etwas niedrigeren Empfindlichkeit kann das magnetempfindliche Volumen noch weiter reduziert werden, was bei den bekannten Magnetfeldsenoren nur schwer möglich ist, da dies eine Verkürzung der Diffusionslänge verlangen würde.

In der Darstellung der Fig. 5 schneidet die Verlängerung des oberen Teils der Kennlinie $I_C = f (V_{CE})$ die Ordinate in einem Punkt C' mit dem Stromwert I' und die Abzisse in einem Punkt D' mit dem Spannungswert $-V_E$.

Die niedrige Relativstrom-Empfindlichkeit bisheriger Magnetotransistoren beruht auf der Tatsache, dass

- deren Emitter-Wirkungsgrad zu hoch ist und

- deren Entwurf nicht optimiert ist in Bezug auf die Ablenkung der Ladungsträger durch die Lorentzkraft und in Bezug auf die Wirkungen der Magnetokonzentrationen.

In der vorliegenden Erfindung wird zur Erzeugung einer hohen Relativstrom-Empfindlichkeit

- einerseits der Emitter-Wirkungsgrad drastisch gesenkt im Vergleich zu demjenigen bekannter Magnetotransistoren und auch im Vergleich zu demjenigen normaler Bipolartransistoren; dies wird erzielt durch die Verwendung einer sehr dünnen und/oder einer sehr niedrig mit Fremdatomen dotierten Emitterschicht 6 und

- anderseits ein in Sperrichtung gepolter P/N-Uebergang, nämlich der P/N -Uebergang der Basis-Schicht 2 zum Siliziumsubstrat 1, verwendet, dies im Gegensatz zu den bisher verwendeten Magnetotransistoren, bei denen das Siliziumsubstrat die Rolle der Basis übernimmt.

4

Zur Realisierung eines hochempfindlichen Magnetotransistors mussten somit folgende Vorurteile überwunden werden:

- Die Ansicht, dass der Emitter unbedingt aus hochdotiertem Material bestehen müsse und
- die Ansicht, dass es genüge, das Siliziumsubstrat als Basis zu verwenden.

Der in Sperrrichtung gepolte P/N-Uebergang hat die folgenden drei Aufgaben zu erfüllen:

- Den Emitter-Wirkungsgrad weiter zu verkleinern durch ein Auffangen der meisten durch den Emitter injizierten Ladungsträger,
- das magnetempfindliche Volumen zu definieren und möglichst klein zu halten und
- die in der Darstellung der Zeichnung horizontal injizierten jedoch zum Siliziumsubstrat abgelenkten sowie die senkrecht injizierten unnützen Elektronen aufzufangen.

Der Emitter-Wirkungsgrad ist

$$\gamma = I_{iE} / I_{iB},$$

wobei $I_{iE}$ der in der Basis-Schicht 2 vom Emitter injizierte Strom und $I_{iB}$ der in der Emitter-Schicht 6 von der Basis injizierte Strom ist.

Durch Vergrösserung von $I_{iB}$ kann der Emitter-Wirkungsgrad $\gamma$ wirkungsvoll verkleinert werden. Dies geschieht z.B. durch Addition einer oder mehrerer Stromkomponenten $I_B$, die allerdings keine Vergrösserung von $I_{iE}$ verursachen dürfen, mittels einer der folgenden vier Methoden:

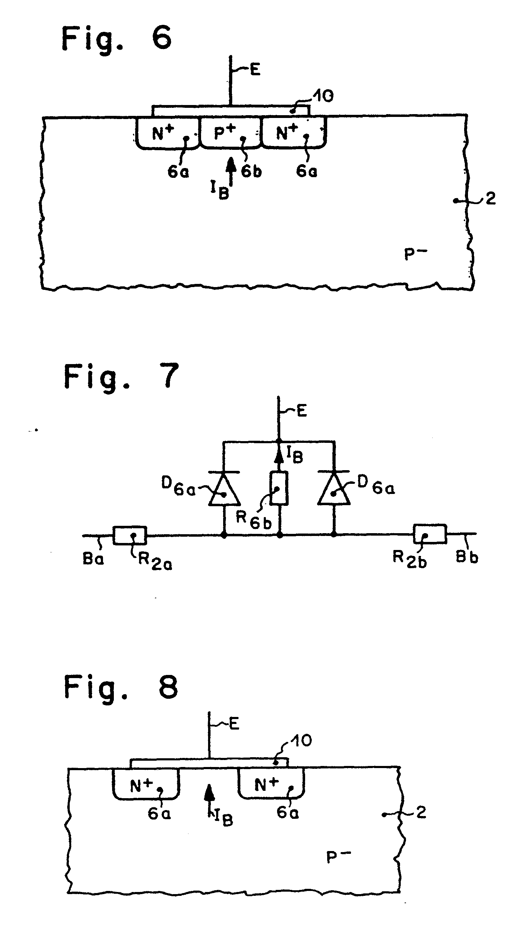

1. Aufteilung der Emitter-Schicht 6 ohne Zwischenräume in drei parallelen Unterschichten 6a bzw. 6b gemäss der Fig. 6, wobei die beiden äusseren Unterschichten 6a aus N+-Material, d.h. aus stark dotiertem Material vom umgekehrten Leitfähigkeitstyp als die Basis-Schicht 2 bestehen. Die zentrale Unterschicht 6b besteht dagegen aus stark dotiertem Material vom gleichen Leitfähigkeitstyp wie die Basis-Schicht 2, d.h. aus P+ -Material. Alle drei Unterschichten sind mit einer einzigen Metallelektrode 10 bedeckt. Die Uebergänge der äusseren Unterschichten 6a zur Basis-Schicht 2 bilden je eine Diode $D_{6a}$, dessen Kathode mit dem Emitteranschluss E verbunden ist. Die zentrale Unterschicht 6b besitzt einen Innenwiderstand $R_{6b}$. Die beiden Dioden $D_{6a}$ sowie der Innenwiderstand $R_{6b}$ sind gemäss dem Ersatzschaltbild der Fig. 7 elektrisch parallelgeschaltet und liegen zwischen dem Emitteranschluss E und einem gemeinsamen Pol der beiden Basiswiderstände $R_{2a}$ und $R_{2b}$ der Basis-Schicht 2. $R_{2a}$ stellt den Widerstand des Teils der Basis-Schicht 2 dar, der zwischen dem Basisanschluss Ba und der Emitter-Schicht liegt, und $R_{2b}$ der Widerstand desjenigen Teils der zwischen dem Basisanschluss Bb und der Emitter-Schicht liegt. Der elektrische Strom $I_B$ im Widerstand $R_{6b}$ ist ein reiner Leckstrom, der die eigentlichen Emitter-Schichten, d.h. die Unterschichten 6a und 6b kurzschliesst und somit keinen Beitrag an $I_{iE}$ leistet.

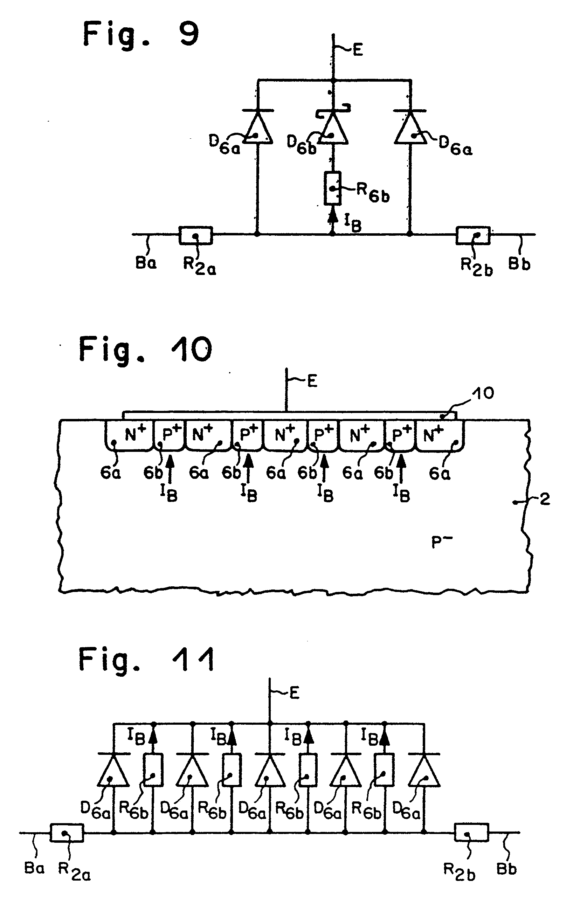

2. Gemäss der Fig. 8 Weglassung der zentralen Unterschicht 6b in der Methode 1 und Ersatz durch einen Teil der Basis-Schicht 2. Dieser Teil ist nun zwischen den beiden Unterschichten 6a gelegen und bildet zusammen mit der Metallelektrode 10 eine Schottky-Diode $D_{6b}$, die mit einem Verlustwiderstand $R_{6b}$ in Reihe geschaltet ist. Diese Reihenschaltung ist den Dioden $D_{6a}$ parallelgeschaltet und schliesst diese kurz, so dass der Strom $I_B$ in der Reihenschaltung keinen Beitrag an $I_{iE}$ leistet. Das elektrische Ersatzschaltbild der Fig. 8 ist in der Fig. 9 dargestellt.

3. Aufteilung der Emitter-Schicht 6 gemäss der Fig. 10 ohne Zwischenräume, in eine Vielzahl von sich abwechselnden parallelen Unterschichten 6a und 6b aus stark dotiertem N+- bzw. P+-Material. Die Unterschichten 6b besitzen alle je einen Innenwiderstand $R_{6b}$, in dem je ein Leckstrom $I_B$ fliesst, der keinen Beitrag an $I_{iE}$ leistet. Die Methode 3 entspricht der Methode 1, nur dass hier nicht zwei bzw. eine, sondern je eine Vielzahl von Unterschichten 6a bzw. 6b vorhanden sind. Alle Leckströme $I_B$ addieren sich und leisten somit einen besonders grossen Beitrag an die Vergrösserung von $I_{iB}$ und damit an die Verkleinerung von $\gamma$.

4. Aufteilung der Emitter-Schicht 6 gemäss der Fig. 12 in eine Vielzahl von parallelen Unterschichten 6a aus stark dotiertem N+-Material, die alle durch einen Teil der Basis-Schicht 2 voneinander getrennt sind. Jedes dieser Teile der Basis-Schicht 2 bildet zusammen mit der Metallelektrode 10 eine Schottky-Diode $D_{6b}$, die jeweils mit einem Verlustwiderstand $R_{6b}$ in Reihe geschaltet ist. In jeder dieser Reihenschaltungen fliesst ein Leckstrom $I_B$, der keinen Beitrag an $I_{iE}$ leistet.

Die Methode 4 entspricht der Methode 2, nur das hier nicht zwei, sondern eine Vielzahl von Unterschichten 6a vorhanden sind. Alle Leckströme $I_B$ addieren sich und vergrössern somit besonders stark $I_{iB}$ ohne einen Beitrag an $I_{iE}$ zu leisten.

Die Fig. 11 und die Fig. 13 zeigen jeweils das elektrische Ersatzschaltbild der Fig. 10 und der Fig. 12.

Die bisher beschriebenen Magnetfeldsensoren können als Strom-Meßwandler am Eingang von Elektrizitätszählern eingesetzt werden zum Messen des verbrauchten elektrischen Stromes. Dieser Strom-Meßwert dient dann anschließend in Zusammenhang mit einem Spannungs-Meßwert zur Ermittlung der verbrauchten elektrischen Energie.

Zwecks Verdichtung der Magnetfelder wird das den Magnetfeldsensor enthaltene Substrat in bevorzugten Anordnungen im oder in der unmittelbaren Nähe vom Luitspalt eines Magnetkernes mit seiner Oberfläche parallel zu den Magnetfeldern angeordnet, z.B. gemäß einer der in der DE-OS 29 18 483 beschriebenen Montagemethoden. In diesen Fällen genügt es, ein dort verwendetes Substrat mit darauf montiertem Magnetfilm durch den Magnetfeldsensor zu ersetzen.

Bisher wurde angenommen, daß der gesamte verbrauchte Strom im Magnetfeldsensor gemessen wird. Ist dieser Strom jedoch sehr groß, genügt es, einen konstanten und bekannten Eruchteil dieses Stromes dem

5

**0 099 979**

Magnetfeldsensor in Form eines Magnetfeldes zuzuführen.

Dies geschieht nach einer der zwei nachfolgenden Methoden:.

Bei einer ersten, unter anderem in der DE-PS 30 M8 308 beschriebenen Methode mit Stromteiler wird ein Teil des zu messenden Stromes mit Hilfe eines Shunts vom Magnetfeldsensor ferngehalten.

Bei einer zweiten, in der US-FS 42 40 059 beschriebenen Brücken-Methode, wird der zu messende Strom einer Meßbrücke dermaßen zugeführt, daß nur der im Diagonalzweig der Meßbrücke fließende Teil des zu messenden Stromes den Magnetfeldsensor erreicht und Von diesem ausgewertet wird.

## Patentansprüche

1. Magnetfeldsensor bestehend aus einem nur eine einzige Emitter-Schicht (6) enthaltenden, lateralen bipolaren Magnetotransistor, dessen schwach mit Fremdatomen dotierte Basis-Schicht (2) mindestens einen stark mit Fremdatomen dotierten Basis-Kontakt (4, 8) besitzt, wobei die Emitter-Schicht (6), Kollektor-Schichten (5, 7) und die Basis-Kontakte (4, 8) nebeneinander auf einer Reihe angeordnet sind,
dadurch gekennzeichnet ,
daß die Basis-Schicht (2) als Wanne in einem schwach mit Fremdatomen dotiertem Siliziumsubstrat (1) vom umgekehrten Material-Leitfähigkeitstyp an dessen Oberfläche enthalten ist,
daß mindestens ein Kollektor-Sekundärkontakt (3a, 3b) außerhalb der Wanne an der Oberfläche im Siliziumsubstrat (1) vorhanden ist, an den eine Spannung ($+ V_{c1}$) zu legen ist, die den P/N-Übergang (2; 1) zwischen der Basis-Schicht (2) und dem Siliziumsubstrat (1) in Sperrichtung polt, und
daß die Dicke und/oder die Dotierung der Emitter-Schicht (6) so bemessen ist, daß ihre Resistivität größer als 100 Ohm pro Quadrat ist.

2. Magnetfeldsensor nach Anspruch 1,
dadurch gekennzeichnet,
daß die einzig vorhandene Emitter-Schicht (6) möglichst dünn, jedoch dicker als 0,5 μm ist.

3. Magnetfeldsensor nach Anspruch 1 oder 2,
dadurch gekennzeichnet,
daß die einzig vorhandene Emitter-Schicht (6) ohne Zwischenräume in zwei äußere Unterschichten (6a) und eine zentrale Unterschicht (6b) aufgeteilt ist, die alle parallel verlaufen und stark dotiert sind und bei denen die zentrale Unterschicht (6b) vom gleichen und die äußeren Unterschichten (6a) vom umgekehrten Material-Leitfähigkeitstyp sind wie die Basis-Schicht (2).

4. Magnetfeldsensor nach Anspruch 3,
dadurch gekennzeichnet,
daß die zentrale Unterschicht (6b) aus einem Teil der Basis-Schicht (2) besteht.

5. Magnetfeldsensor nach Anspruch 1 oder 2,
dadurch gekennzeichnet,
daß die einzig vorhandene Emitter-Schicht (6) ohne Zwischenräume in eine Vielzahl von sich abwechselnden, stark dotierten, parallelen Unterschichten (6a, 6b) aus N+- bzw. P+-Material aufgeteilt ist.

6. Magnetfeldsensor nach Anspruch 5,
dadurch gekennzeichnet,
daß diejenigen Unterschichten (6b), die vom gleichen Material-Leitfähigkeitstyp sind wie die Basis-Schicht (2), aus einem Teil der Basis-Schicht (2) bestehen.

7. Verwendung des Magnetfeldsensors nach einem der Ansprüche 1 bis 6 als Stromsensor im Eingangskreis eines Elektrizitätszählers.

8. Verwendung des Magnetfeldsensors nach einem der Ansprüche 1 bis 6 zu dem im Anspruch 7 genannten Zweck mit der Maßgabe, daß das den Magnetfeldsensor enthaltende Substrat (1) im oder in der unmittelbaren Nähe vom Luftspalt eines Magnetkerns mit seiner Oberfläche parallel zu den hlagnetfeldern angeordnet ist.

9. Verwendung des Magnetfeldsensors nach einem der Ansprüche 1 bis 6 zu dem im Anspruch 7 genannten Zweck mit der Maßgabe, daß ein Stromteiler den zu messenden Strom teilt und ein Shunt einen Teil des zu messenden Stromes vom Magnetfeldsensor fernhält.

10. Verwendung des Magnetfeldsensors nach einem der Ansprüche 1 bis 6 zu dem im Anspruch 7 genannten Zweck mit der Maßgabe, daß der zu messende Strom derart einer Meßbrücke zugeführt ist, daß nur der in deren Diagonalzweig fließende Teil des zu messenden Stromes den Magnetfeldsensor erreicht.

## Claims

1. A magnetic field sensor ccmprising a lateral bipolar magneto-transistor which includes only a single emitter layer (6) and whose base layer (2) which is weakly doped with impurity atoms has at least one base contact (4, 8) which is heavily doped with impurity atoms, wherein the emitter layer (6), collector layers (5, 7) and the base contacts (4, 8) are arranged in side-by-side relationship in a row, characterised in that
the base layer (2) is contained in the form of a well in a silicon substrate (1) which is weakly doped with

6

impurity atoms, of opposite conductivity type at the surface thereof,

at least one collector secondary contact (3a, 3b) is provided outside the well at the surface in the silicon substrate (1) to which a voltage ($+V_{c1}$) is to be applied, which biases the P/N-junction (2; 1) between the base layer (2) and the silicon substrate (1) in the nonconducting direction, and

the thickness and/or the doping of the emitter layer (6) is such that the resistivity thereof is greater than 100 ohms per square metre.

2. A magnetic field sensor according to claim 1 characterised in that the only emitter layer (6) present is to te as thin as possible but thicker than 0.5 um.

3. A magnetic field sensor according to claim 1 or claim 2 characterised in that the only emitter layer (6) present is divided without intermediate spaces into two outer sub-layers (6a) and a central sub-layer (6b) which all extend in parallel relationship and which are heavily doped and in which the central sub-layer (6b) is of the same conductivity type as the base layer (2) and the outer sub-layers (6a) are of opposite conductivity type to the base layer (2).

4. A magnetic field sensor according to claim 3 characterised in that the central sub-layer (6b) ccmprises a portion of the base layer (2).

5. A magnetic field sensor according to claim 1 or claim 2 characterised in that the only emitter layer (6) present is divided without intermediate spaces into a plurality of alternating, heavily doped, parallel sub-layers (6a, 6b) of N+- and P+-material respectively.

6. A magnetic field sensor according to claim 5 characterised in that those sub-layers (6b) which are of the same conductivity type as the base layer (2) ccmprise a portion of the base layer (2).

7. Use of the magnetic field sensor according to one of claims 1 to 6 as a current sensor in the input circuit of an electricity meter.

8. Use of the magnetic field sensor according to one of claims 1 to 6 for the purpose set forth in claim 7 provided that the substrate (1) containing the magnetic field sensor is arranged in or in the direct vicinity of the air gap of a magnetic core with its surface parallel to the magnetic fields.

9. Use of the magnetic field sensor according to one of claims 1 to 6 for the purpose set forth in claim 7 with the proviso that a current divider divides the current to be measured and a shunt keeps a part of the current to be measured away from the magnetic field sensor.

10. Use of the magnetic field sensor according to one of claims 1 to 6 for the purpose set forth in claim 7 with the proviso that the current to te measured is supplied to a measuring bridge in such a way that only the part of the current to te measured, which flows in the diagonal arm of the measuring bridge, reaches the magnetic field sensor.

## Revendications

1. Capteur de champ magnétique constitué par un magnétotransistor latéral bipolaire, ne contenant qu'une seule couche d'émetteur (6) et dont la couche de base (2), faiblement dopée par des atomes étrangers, possède au moins un contact de base (4, 8) fortement dopé par des atomes étrangers, la couche d'émetteur (6), les couches de collecteur (5, 7) et les contacts de basr (4, 8) étant disposés cote-à-cote selon une rangée, caractérisé en ce

que la couche de base (2) est réalisée sous la forme d'une cuvette dans un substrat en silicium (1) faiblement dopé avec des atomes étrangers et dont le type de conductivité du matériau est inversé au niveau de sa surface supérieure,

que dans la surface supérieure du substrat en silicium (1) et à l'extérirur de la cuvettte se trouve prévu au moins un contact secondaire de collecteur (3a, 3b), auquel doit être appliquée une tension ($+V_{c1}$), qui polarise en sens inverse la jonction P-N (2; 1) entre la couche de base (2) et le substrat en silicium, et

que l'épaisseur et/ou le dopage de la couche d'émetteur (6) est dimensionné de telle sorte que la résistivité de cette couche est supérieure à 100 ohms par carré.

2. Capteur de-champ magnétique selon la revendication 1, caractérisé en ce que la couche unique d'émetteur (6) est aussi mince que possible, mais est d'une épaisseur supérieure à 0,5 μm.

3. Capteur de champ magnétique selon la revendication 1 ou 2, caractérisé en ce que la couche unique d'émetteur (6) est subdivisée, sans espaces intercalaires, en deux sous-couches extérieures (6a) et en une sous-couche centrale (6b), qui toutes sont parallèles et fortement dopées et parmi lesquelles la sous-couche centrale (6b) posséde le même type de conductivité que le matériau de la couche de base (2) et les sous-couches extérieures (6a) possèdent le type de conductivité opposé au matériau de la couche de base (2).

4. Capteur de champ magnétique selon la revendication 3, caractérisé en ce que la sous-couche centrale (6b) est constituée par une partie de la couche de base (2).

5. Capteur de champ magnétique selon la revendication 1 ou 2, caractérisé en ce que la couche unique d'émetteur (6) est subdivisée, sans espaces intercalaires, en une multiplicité de sous-couches parallèles alternées (6a, 6b), fortement dopées et constituées en un matériau de type N+ ou P+.

6. Capteur de champ magnétique selon la revendication 5, caractérisé en ce que les sous-couches (6b), qui possèdent le même type de conductivité que le matériau de la couche de base (2), sont constituées par une partie de la couche de base (2).

7. Utilisation du capteur de champ magnétique selon l'une des revendications 1 à 6 en tant que capteur de courant dans le zircuit d'entrée d'un compteur d'électricité.

8. Utilisation du capteur de champ magnétique selon l'une des revendications 1 à 6 dans le but indiqué dans la revendication 7, avec la condition selon laquelle le substrat (1) contenant le capteur de champ magnétique est disposé dans ou à proximité immédiate de l'entrefer d'un noyau magnétique, avec sa surface supérieure parallèle aux champs magnétiques.

9. Utilisation du capteur de champ magnétique selon l'une des revendications 1 à 6 dans le but indiqué dans la revendication 7, avec la condition consistant en ce qu'un diviseur de courant subdivise le courant à mesurer et qu'un shunt maintient une partie du courant à mesurer, à l'écart du capteur du champ magnétique.

10. Utilisation du capteur de champ magnétique selon l'une des revendications 1 à 6 dans le but indiqué dans la revendication 7, avec la condition consistant en ce que le courant à mesurer est envoyé à un pont de mesure de telle sorte que seule la partie du courant à mesurer, qui circule dans la branche diagonale de ce pont, atteint le capteur de champ magnétique.

# Fig. 1

# Fig. 2

# Fig. 3

# Fig. 4

# Fig. 5

# Fig. 6

# Fig. 7

# Fig. 8

# Fig. 9

# Fig. 10

# Fig. 11

# Fig. 12

# Fig. 13